# EUROPÄISCHE PATENTANMELDUNG

(11) **EP 1 313 109 A2**
(43) Veröffentlichungstag der Anmeldung: **21.05.2003**
(21) Anmeldenummer: 02022650.2
(22) Anmeldetag: 09.10.2002
(51) Int. Cl.: H01C 17/28, H01C 1/144

(54) **Oberflächenmontierbarer elektrischer Widerstand**

(30) Priorität: 29.10.2001 DE 20117650 U
(71) Anmelder: Isabellenhütte Heusler GmbH KG, D-35683 Dillenburg (DE)
(72) Erfinder: Hetzler, Ullrich, Dr., 35688 Dillenburg-Oberscheld (DE)
(74) Vertreter: Heusler, Wolfgang, Dipl.-Ing.

(57) **Zusammenfassung**

Ein niederohimiger SMD-Messwiderstand hat an entgegengesetzten Kanten (31, 32) eines plattenförmigen metallischen Widerstandselements (3) angeschweißte Z-förmig gebogene Anschlusselemente (1, 2) aus gut leitendem Metall, deren Enden (22) unter elastischer Verbiegung der Anschlusselemente (1, 2) relativ zueinander bewegbar sind. Die Herstellung der Widerstände erfolgt aus einem elektronenstrahlgeschweißten Verbundmaterialband.

## Beschreibung

Die Erfindung betrifft einen oberflächenmontierbaren elektrischen Widerstand gemäß dem Oberbegriff des Anspruchs 1, eine Strommessanordnung mit einem solchen Widerstand sowie ein Verfahren zu seiner Herstellung.

Insbesondere handelt es sich um für hohe Dauerbelastung von einigen Watt ausgelegte niederohmige Präzisions-Strommesswiderstände (Shunts) in SMD-Bauweise, deren Widerstands- und Anschlusselemente z. B. durch Elektronenstrahlschweißen miteinander verbunden sind. Ein SMD-Widerstand der betrachteten Gattung, der beispielsweise bei einem Wert in der Größenordnung von 1 mΩ problemlos mehr als 3 Watt verträgt und mit guten elektrischen und mechanischen Eigenschaften relativ einfach in großen Stückzahlen aus einem Verbundmaterialband hergestellt werden kann, ist aus der EP 0 605 800 B1 bekannt. Ähnliche Widerstände und deren Herstellung sind in der EP 0 716 427 B1 beschrieben.

Bei der Oberflächenmontage der betrachteten Widerstände tritt das Problem auf, dass sich im Betrieb die Lötverbindungen lösen können. SMD-Bauelemente werden bekanntlich mit ihrem ggf. etwas vorspringenden Anschlusselementen flach auf entsprechend angeordnete Anschlussflächen beispielsweise einer Schaltungsplatte aufgelötet.

Demgemäss liegt der Erfindung die Aufgabe zugrunde, einen Widerstand bzw. eine Strommessanordnung mit einem solchen Widerstand anzugeben, der die Lötverbindungen weniger stark belastet als bisher.

Diese Aufgabe wird durch die Merkmale der Ansprüche gelöst.

Durch die Erfindung wird erreicht, dass ohne Änderung der vorteilhaften Eigenschaften der bekannten geschweißten Widerstände zuverlässige Lötverbindungen wesentlich dauerhafter als bisher bestehen.

Ein zusätzlicher Vorteil besteht darin, dass der hier beschriebene SMD-Widerstand einfacher als die gattungsgemäßen bekannten Widerstände als vierpoliger Messwiderstand ausgebildet werden kann.

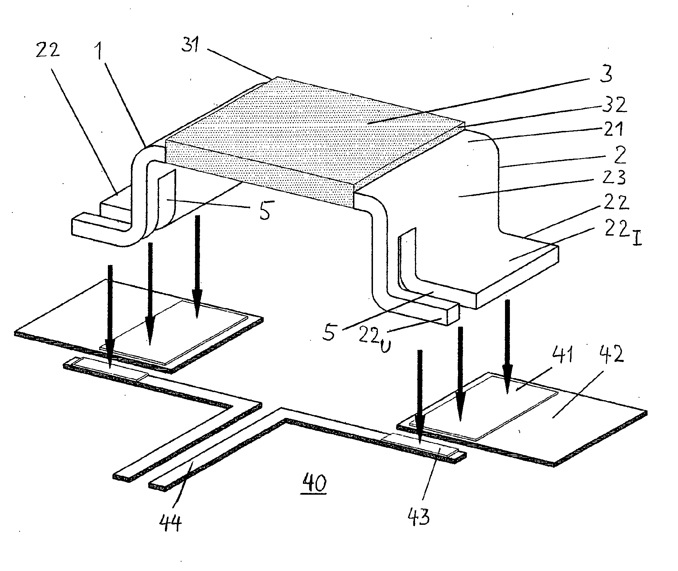

An dem in der Zeichnung schematisch dargestellten SMD-Messwiderstand wird die Erfindung näher erläutert.

Der dargestellte SMD-Messwiderstand besteht aus dem metallischen plattenförmigen ebenen Widerstandselement 3 und den beiden ebenfalls plattenartigen, aber darstellungsgemäß annähernd Z-förmig gebogenen Anschlusselementen 1 und 2 mit parallel zu dem Widerstandselement liegenden oberen Randstreifen 21, den hierzu parallelen Endstreifen 22 und den zwischen den Rand- und Endstreifen 21, 22 quer zu der Hauptebene des Widerstandselements 3 verlaufenden ebenfalls streifenförmigen Stegteilen 23. Die beiden Anschlusselemente 1 und 2 sind mit den an das Widerstandselemente 3 anstoßenden Kanten oder Stirnflächen ihrer Randstreifen 21 an die zueinander entgegengesetzten Kanten oder Stirnflächen 31 und 32 des Widerstandselements 3 angeschweißt. Es kann sich um eine Elektronenstrahlschweißverbindung handeln, die gemäß den erwähnten EP 0 605 800 und 0 716 427 realisiert werden kann, jedenfalls aber um eine echte Schweißverbindung, bei der (im Gegensatz zu Lötverbindungen) die zu verbindenden Metallbereiche zumindest lokal selbst aufgeschmolzen worden sind. Das Widerstandselement besteht zweckmäßig aus einer der hierfür bekannten Kupferlegierungen (z.B. CuMnNi), während die Anschlusselemente aus Metall hoher Leitfähigkeit wie z.B. Kupfer bestehen.

An den in der Zeichnung unsichtbaren Unterseiten der beiden Endstreifen 22 wird der dargestellte Messwiderstand in SMD-Technik z.B. auf eine gedruckte Schaltung 40 aufgelötet, wie durch die Richtungspfeile der Zeichnung angedeutet ist und nachfolgend noch näher erläutert wird.

Erfindungsgemäß sind die dem Widerstandselement 3 abgewandten Endstreifen 22 der Anschlusselemente 1, 2 unter elastischer Verbiegung der zwischen den Endstreifen 22 und dem Widerstandselement 3 liegenden Stegteile 23 der Anschlusselemente 1, 2 parallel zu den Hauptflächenebenen des Widerstandselements 11 relativ zueinander bewegbar. Dies wird gemäß dem dargestellten Ausführungsbeispiel dadurch erreicht, dass die Länge der streifenförmigen Stegteile 23 der Anschlusselemente 1, 2, die zwischen deren dem Widerstandselement 3 abgewandten Endstreifen 22 und dem Widerstandselement liegen, in der quer zu dessen Hauptflächenebenen verlaufenden Richtung wesentlich, d.h. in für die gewünschte elastische Biegbarkeit ausreichendem Maße größer ist als die senkrecht zu den Hauptebenen der abgebogenen Stegteile 23 gemessene Dicke dieser Stegteile. Bei einer typischen Ausführungsform des stark vergrößert dargestellten Widerstands kann bei einer Dicke der Stegteile von weniger als 1 mm diese Länge (oder die Höhe der Unterseite des Widerstandselements 3 über den Anschlussflächen der Schaltung 40) wenige mm betragen. Die Länge soll mindestens etwa das drei- oder vierfache der Dicke betragen und wird nach oben hauptsächlich durch die in der Praxis mögliche Bauhöhe begrenzt.

Die Endstreifen 22 des Widerstands sind darstellungsgemäß durch die Schlitze 5, die sich parallel zu den Hauptflächenebenen des Widerstandselements 3 und der Endstreifen 22 und quer zu den verschweißten Stirnflächen durch die Endstreifen 22 erstrecken und sich darstellungsgemäß nach oben ein Stück in den Stegteil 23 fortsetzen, in einen breiten Teil 22_{I} und einen schmaleren Teil 22_{U} unterteilt, wodurch ein vierpoliger Messwiderstand gebildet wird. Bei dessen SMD-Montage werden die beiden Teile 22_{I} auf Stromanschlüsse 41 relativ breiter Stromleiter 42 der Schaltung 40 und die Teile 22_{U} auf gesonderte Spannungsanschlüsse 43 von Messleitungen 44 gelötet. Die 4-Leiter-Anordnung ist bei Strommessschaltungen an sich bekannt und üblich.

Die Herstellung des dargestellten Widerstands erfolgt durch Abtrennen von oder Ausstanzen aus dem in den EP 0 605 800 oder 0 716 427 beschriebenen langen Verbundmaterialband, das aus einem mittleren Band aus der Widerstandslegierung und mit dessen Längskanten verschweißten Bändern aus dem Metall hoher Leitfähigkeit besteht. Das Abtrennen bzw. Ausstanzen kann in einem Stanz- und Biegewerkzeug erfolgen, in dem auch die Verbiegung der ursprünglich plattenförmigen ebenen Anschlusselemente 1 und 2 in die dargestellte Z-Form durchgeführt werden kann. Vorzugsweise werden hierbei nur die Anschlusselemente verbogen, da eine Kaltverformung des Widerstandselements 3 unerwünscht wäre und insbesondere dessen elektrische Stabilität beeinträchtigen könnte. Die Schlitze 5 können ebenfalls ausgestanzt oder auf andere Weise erzeugt werden.

## Patentansprüche

1. Oberflächenmontierbarer elektrischer Widerstand, insbesondere niederohmiger Messwiderstand,
mit einem aus einer metallischen Widerstandslegierung bestehenden plattenförmigen Widerstandselement (3)
und mit zwei durch das Widerstandselement voneinander getrennten Anschlusselementen (1, 2) aus Metall hoher Leitfähigkeit, die sich streifenförmig längs zueinander entgegengesetzte Kanten (31, 32) des Widerstandselements (3) erstrecken und an diese Kanten angeschweißt sind,
wobei die Anschlusselemente (1, 2) von der Ebene der einen Hauptfläche des Widerstandselements (3) vorspringen,
**dadurch gekennzeichnet, dass** die dem Widerstandselement (3) abgewandten Enden (22) der Anschlusselemente (1, 2) unter elastischer Verbiegung der zwischen den Enden (22) und dem Widerstandselement (3) liegenden Teile (23) der Anschlusselemente (1, 2) parallel zu der Hauptflächenebene des Widerstandselements (3) relativ zueinander bewegbar sind.

2. Widerstand nach Anspruch 1 oder dessen Oberbegriff,
**dadurch gekennzeichnet, dass** die Länge der streifenförmigen Teile (23) der Anschlusselemente (1, 2), die zwischen deren dem Widerstandselement (3) abgewandten Enden (22) und dem Widerstandselement liegen, in der quer zu dessen Hauptflächenebene verlaufenden Richtung wesentlich größer ist als die senkrecht zu der Hauptflächenebene der streifenförmigen Teile (23) gemessene Dicke dieser Teile (23).

3. Widerstand nach Anspruch 2, **dadurch gekennzeichnet, dass** die genannte Länge mindestens das Dreifache der genannten Dicke beträgt.

4. Widerstand nach einem der vorangehenden Ansprüche,
**dadurch gekennzeichnet, dass** die Enden der Anschlusselemente (1, 2) durch wenigstens annähernd parallel zu der Hauptebene des plattenförmigen Widerstandselements (1) abgebogene flache Streifen (22) gebildet sind.

5. Widerstand nach Anspruch 4, **dadurch gekennzeichnet, dass** die abgebogenen Endstreifen (22) jeweils durch einen Schlitz (5) in je zwei getrennte Teile (22_{U}, 22_{I}) vorzugsweise unterschiedlicher Größe unterteilt sind, von denen der eine als Stromanschluss und der andere als Messspannungsanschluss des vierpoligen Messwiderstands verwendbar ist.

6. Widerstand nach Anspruch 5, **dadurch gekennzeichnet, dass** die Schlitze (5) parallel zu dessen Hauptflächenebene des Widerstandselements (1) und quer zu dessen mit den Anschlusselementen (1, 2) verschweißten Kanten (32) durch die Endstreifen (22) verlaufen.

7. Strommessanordnung mit einem Widerstand nach Anspruch 5 oder 6, der mit seinen abgebogenen Endstreifen (22) auf flachen Leiterbahnen (42, 44) einer Schaltung (40) montiert ist,
wobei der eine Teil (22_{I}) jedes Endstreifens (22) je einen Stromanschluss (41) und sein anderer, vorzugsweise kleinerer Teil (22_{U}) je einen Messspannungsanschluss (43) der Schaltung (40) kontaktiert.

8. Verfahren zum Herstellen eines Widerstands nach einem der Ansprüche 1 bis 6, **dadurch gekennzeichnet, dass**
von einem langen Verbundmaterialband, das aus einem mittleren Band aus einer metallischen Widerstandslegierung und mit dessen Längskanten verschweißten Bändern aus einem Metall hoher elektrischer Leitfähigkeit besteht, quer zu der Bandlängsrichtung ein Stück abgetrennt oder ausgestanzt wird
und die beiden aus dem Metall hoher Leitfähigkeit bestehenden Randteile (1, 2) dieses Stücks in eine Z-Form mit quer zu der Ebene des aus der Widerstandslegierung bestehenden Mittelteils (3) abstehenden Stegteilen (23) und parallel zu der Ebene des Mittelteils (3) liegenden Endstreifen (22) gebogen werden.

9. Verfahren nach Anspruch 8, **dadurch gekennzeichnet, dass** der Biegevorgang in dem zum Abtrennen oder Ausstanzen verwendeten Werkzeug durchgeführt wird.
